# FASCICULE DE BREVET EUROPEEN

(11) **EP 0 930 711 B1**
(45) Date de publication et mention de la délivrance du brevet: **04.10.2006**
(21) Numéro de dépôt: 98410151.9
(22) Date de dépôt: 17.12.1998
(51) Int. Cl.: H03K 17/725

(54) **Thyristor bidirectionnel**
Zweirichtungsthyristor
Bidirectional thyristor

(30) Priorité: 22.12.1997 FR 9716640
(43) Date de publication de la demande: 21.07.1999
(73) Titulaire: STMicroelectronics S.A., 92120 Montrouge (FR)
(72) Inventeur: Rault, Pierre, 37540 Saint Cyr sur Loire (FR); Bernier, Eric, 37390 Mettray (FR)
(74) Mandataire: de Beaumont, Michel

(56) Documents cités:
- EP-A- 0 325 301
- EP-A- 0 785 577
- EP-A- 0 793 344
- DE-A- 2 631 474
- US-A- 4 825 272
- R. POSPISIL: "A 500V DIELECTRIC PROCESS FOR VERY HIGH VOLTAGE INTEGRATED CIRCUITS" ELECTRO /86 AND MINI/MICRO NORTHEAST CONFERENCE RECORD, vol. 11, 1 décembre 1986, pages 1-7, XP002072634 LOS ANGELES,US

## Description

La présente invention telle que la définissent les revendications concerne les commutateurs bidirectionnels destinés à commander une charge raccordée au secteur. L'invention s'applique plus particulièrement aux commutateurs "normalement fermés", c'est-à-dire qui sont spontanément à l'état passant et dont la commande consiste à ouvrir le commutateur pour bloquer l'alimentation de la charge.

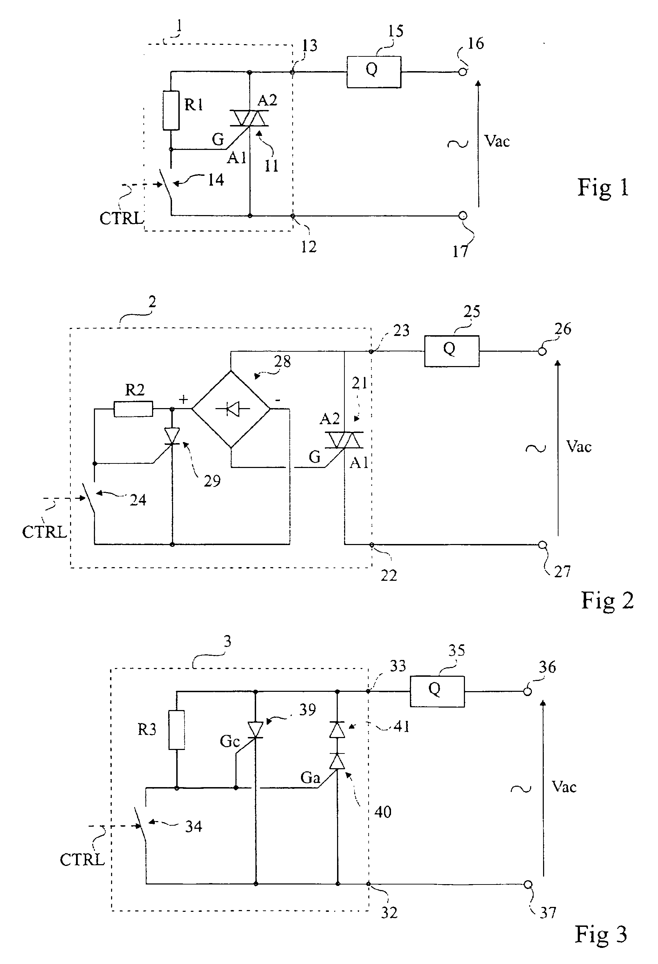

La figure 1 représente un premier exemple de commutateur bidirectionnel 1 normalement fermé. Le commutateur 1 est essentiellement constitué d'un triac 11 monté entre deux bornes 12, 13 de puissance. La gâchette G du triac 11 est reliée, par l'intermédiaire d'un interrupteur 14 commandable, à une première borne 12 de puissance ou première anode A1 du triac 11. Une résistance R1 de forte valeur relie la gâchette G du triac 11 à une deuxième borne 13 de puissance ou deuxième anode A2 du triac, de sorte que l'association en série de la résistance R1 et de l'interrupteur 14 est montée en parallèle sur le triac 11.

Le commutateur 1 est destiné à être connecté en série avec une charge 15 (Q) entre deux bornes 16, 17 d'application d'une tension d'alimentation alternative Vac, par exemple, la tension du secteur.

L'interrupteur de commande 14 peut être un interrupteur à commande manuelle ou recevoir un signal CTRL de commande fourni par un circuit de commande approprié.

Le fonctionnement d'un commutateur tel que représenté à la figure 1 est le suivant.

On suppose, qu'au repos, l'interrupteur 14 est ouvert. Quand une tension est appliquée aux bornes du commutateur 1, c'est-à-dire quand une tension alternative est appliquée entre les bornes 16 et 17, un courant circule dans la gâchette G du triac 11 à travers la résistance R1 et amorce le triac qui reste passant tant qu'il est traversé par un courant, c'est-à-dire jusqu'au passage par zéro de l'alimentation alternative. Ce processus se répète à chaque alternance de la tension d'alimentation alternative Vac. Par exemple, au début d'une alternance positive, un courant circule, depuis la borne 13, dans la résistance R1, et de la gâchette G à l'anode A1 du triac 11, jusqu'à ce que ce courant soit suffisant pour amorcer le triac dans le premier quadrant (courants de gâchette et d'anode positifs). Une fois le triac 11 amorcé, le courant circule à travers ce dernier jusqu'à la fin de l'alternance, où le triac se bloque. Au début d'une alternance négative, un courant circule, depuis la borne 12, de l'anode A1 à la gâchette G du triac 11 et dans la résistance R1, jusqu'à ce que ce courant soit suffisant pour amorcer le triac dans le troisième quadrant (courants d'anode et de gâchette négatifs).

La résistance R1 est dimensionnée en fonction du courant de gâchette nécessaire au déclenchement du triac et de la tension d'alimentation maximale acceptable (généralement de l'ordre de 20 volts) pour assurer la mise en conduction du commutateur 1 au début de chaque alternance. Lorsque l'interrupteur 14 est fermé (par une action extérieure au commutateur 1), la gâchette G et l'anode A1 du triac sont court-circuitées et le triac ne peut plus s'amorcer et reste à l'état ouvert.

Un inconvénient d'un commutateur tel que représenté à la figure 1 est que, quand le triac est maintenu à l'état ouvert (interrupteur 14 fermé), la résistance R1 dissipe une puissance élevée. En effet, le courant d'amorçage d'un triac est relativement élevé, ce qui ne permet pas d'utiliser une résistance R1 élevée en respectant l'impératif d'un amorçage à faible tension qui caractérise un commutateur normalement fermé.

Actuellement, les triacs les plus sensibles en amorçage requièrent un courant de gâchette de plusieurs mA. Ce courant d'amorçage élevé est lié à la structure d'un triac. On doit en effet prévoir un courant d'amorçage suffisamment important pour éviter que les charges résiduelles non recombinées dans le semiconducteur provoquent un réamorçage du triac en fin d'alternance.

Par exemple, parmi les triacs les plus sensibles fabriqués par la société SGS-THOMSON Microelectronics, les triacs connus sous la dénomination Z0103 et Z0402 requièrent un courant de gâchette de 3 mA pour être amorcés.

Avec une telle valeur minimale de courant de gâchette et pour une tension d'amorçage de 20 volts, on est conduit à prévoir une résistance R1 de l'ordre de 7 kQ. Ceci conduit à une puissance dissipée de l'ordre de 6 watts lorsque l'interrupteur 14 est fermé et que la tension Vac est celle du secteur à 220 V.

On a déjà proposé la réalisation d'un commutateur bidirectionnel normalement fermé dans lequel la puissance dissipée est sensiblement plus faible qu'avec le commutateur de la figure 1. La figure 2 représente un exemple d'un tel commutateur 2 bidirectionnel normalement fermé, connecté en série avec une charge 25 entre deux bornes 26, 27 d'application d'une tension alternative Vac d'alimentation.

Comme précédemment, un triac 21 est connecté entre deux bornes 22, 23 de puissance du commutateur 2 auxquelles sont respectivement reliées une borne (par exemple, 27) d'application de la tension d'alimentation et une première borne de la charge 25. La gâchette G du triac 21 est reliée à une entrée alternative d'un pont de diodes 28 dont l'autre entrée alternative est reliée à la borne 23, donc à une anode (par exemple, A2) du triac 21. Une résistance R2, en série avec un interrupteur 24 de commande du commutateur 2, est connectée entre les bornes (+) et (-) de tension redressée du pont 28. Un thyristor 29 est monté en parallèle sur l'association en série de la résistance R2 et de l'interrupteur 24, son anode étant connectée à la borne positive (+) de tension redressée du pont 28 et sa cathode étant reliée à la borne négative (-). La gâchette du thyristor 29 est reliée au point de connexion de la résistance R2 et de l'interrupteur 24.

Le fonctionnement du commutateur 2 représenté à la figure 2 est le suivant.

On suppose l'interrupteur 24 ouvert. Au début d'une alternance positive, un courant circule, depuis la borne 23, à travers une première diode du pont 28, la résistance R2, la gâchette et la cathode du thyristor 29, la diode du pont 28 opposée à la première, puis de la gâchette G à l'anode A1 du triac 21. Dès que le courant atteint la valeur nécessaire à l'amorçage du thyristor 29, celui-ci entre en conduction. Par la suite, dès que le courant circulant dans le thyristor 29 devient suffisant pour amorcer le triac 21, ce dernier s'amorce, court-circuitant ainsi l'ensemble des autres composants du commutateur 2. Au début d'une alternance négative, un courant circule depuis la borne 22, de l'anode A1 à la gâchette du triac 21, dans une troisième diode du pont 28, de la cathode à la gâchette du thyristor 29, dans la résistance R2, puis dans une diode du pont 28 opposée à la troisième. Comme précédemment, le commutateur 2 est déclenché en deux temps, par la mise en conduction du thyristor 29 court-circuitant la résistance R2 et l'interrupteur 24, puis par la mise en conduction du triac 21.

On utilise un thyristor 29 afin de disposer d'un composant plus sensible qu'un triac à l'amorçage. En effet, on sait réaliser des thyristors (à gâchette de cathode) dont les courants d'amorçage sont de l'ordre d'une centaine de µA, voire moins. Par conséquent, la résistance R2 peut être dimensionnée avec une valeur beaucoup plus élevée que dans le commutateur représenté à la figure 1. Il en découle que, quand l'interrupteur 24 est fermé pour interdire l'amorçage du thyristor 29 en court-circuitant sa gâchette et sa cathode, la puissance dissipée dans le commutateur 2 est nettement plus faible.

A titre d'exemple particulier, en supposant que le thyristor 29 a un courant d'amorçage de 100 µA et en prenant, pour la tension de déclenchement, la même valeur que précédemment (c'est-à-dire 20 volts), la résistance R2 peut avoir une valeur de l'ordre de 200 kΩ. Il en découle une puissance dissipée de l'ordre de 100 mW quand l'interrupteur 24 est fermé.

Si un tel commutateur permet de pallier à l'inconvénient de puissance dissipée du commutateur de la figure 1, il présente cependant plusieurs inconvénients.

Un premier inconvénient est qu'il requiert un nombre de composants élevé en raison de la présence du pont de diodes 28. De plus, tous ces composants doivent supporter la haute tension d'alimentation alternative (par exemple, environ 220 volts).

Un autre inconvénient est que l'interrupteur 24 n'est pas référencé à la tension d'alimentation alternative Vac mais est référencé à la borne négative de tension redressée du pont 28. Cela rend plus complexe la commande de l'interrupteur 24 et limite les applications dans lesquelles un tel commutateur peut être utilisé. En effet il faut alors utiliser un circuit de commande isolé du secteur (alimentation à transformateur ou utilisant un optocoupleur). Ceci interdit d'utiliser un même circuit de commande pour contrôler plusieurs commutateurs.

La présente invention vise à pallier les inconvénients des commutateurs bidirectionnels normalement fermés connus.

La présente invention vise, plus particulièrement, à proposer un nouveau commutateur bidirectionnel normalement fermé, qui entraîne une faible dissipation de puissance à l'état ouvert et qui ne requiert que peu de composants.

La présente invention vise également à ce que le commutateur bidirectionnel utilise un interrupteur de commande référencé à la tension alternative d'alimentation.

La présente invention vise également à proposer des structures de composants monolithiques intégrant au moins les thyristors du circuit selon la présente invention.

Une caractéristique de la présente invention est de proposer un commutateur utilisant deux thyristors associés respectivement aux alternances positive et négative de la tension alternative d'alimentation. Une autre caractéristique de la présente invention est d'utiliser une même résistance pour amorcer chacun de ces thyristors au début de l'alternance positive ou négative à laquelle il est associé.

Plus précisément, la présente invention prévoit un commutateur bidirectionnel normalement fermé, comportant, en parallèle entre deux bornes de puissance du commutateur, un premier thyristor à gâchette de cathode, dont l'anode est reliée à une première borne de puissance ; un deuxième thyristor à gâchette d'anode, dont l'anode est reliée à une deuxième borne de puissance ; et une résistance en série avec un interrupteur commandable, le point-milieu de cette association en série étant relié aux gâchettes respectives des deux thyristors.

Selon un mode de réalisation de la présente invention, les thyristors sont choisis pour présenter un faible courant d'amorçage.

Selon un mode de réalisation de la présente invention, une diode de protection est intercalée entre la cathode du thyristor à gâchette d'anode et la première borne de puissance.

Selon un mode de réalisation de la présente invention, la résistance est de forte valeur, choisie en fonction des courants d'amorçage respectifs des deux thyristors.

Selon un mode de réalisation de la présente invention, au moins les deux thyristors sont intégrés.

Selon un mode de réalisation de la présente invention, les deux thyristors, la diode de protection et la résistance sont intégrés au sein d'un même circuit.

Selon un mode de réalisation de la présente invention, la résistance est non linéaire.

La présente invention prévoit aussi un composant semiconducteur monolithique intégrant les deux thyristors du commutateur bidirectionnel susmentionné dans lequel ces thyristors sont réalisés sous forme verticale dans une portion d'un substrat de type N faiblement dopé entourée d'un mur d'isolement de type P.

Selon un mode de réalisation de la présente invention, l'anode du thyristor à gâchette d'anode et la cathode du thyristor à gâchette de cathode sont disposées du côté de la face arrière du composant revêtue d'une métallisation unique, la gâchette du thyristor à gâchette de cathode est prise sur le mur d'isolement du côté de la face avant du composant, et la gâchette d'anode du thyristor à gâchette d'anode est constituée d'un anneau entourant un caisson de type P dans lequel est formé une couche de cathode du composant, du côté de la face avant.

Selon un mode de réalisation de la présente invention, l'anode du thyristor à gâchette de cathode et la cathode du thyristor à gâchette d'anode sont disposées du côté de la face arrière du composant revêtue d'une métallisation unique, la gâchette du thyristor à gâchette d'anode est constituée d'un anneau entourant un caisson de type P constituant la région d'anode du thyristor, et la métallisation de gâchette M du thyristor à gâchette de cathode est formée du côté de la face supérieure du substrat sur un caisson de type P contenant une région de type N formant la cathode du thyristor à gâchette de cathode.

Selon un mode de réalisation de la présente invention, l'anode du thyristor à gâchette de cathode et la cathode du thyristor à gâchette d'anode sont disposées du côté de la face arrière du composant et revêtues d'une métallisation unique, la gâchette du thyristor à gâchette d'anode est du type gâchette éloignée et est constituée d'une région de type N formée dans le caisson d'anode du thyristor à gâchette d'anode, d'où il résulte que le thyristor à gâchette d'anode est protégé contre des claquages résultant de tensions inverses élevées, et la métallisation de gâchette M du thyristor à gâchette de cathode est formée du côté de la face supérieure du substrat sur un caisson de type P contenant une région de type N formant la cathode du thyristor à gâchette de cathode.

Selon un mode de réalisation de la présente invention, le composant comprend une région de type P faiblement dopé s'étendant entre le caisson de type P dans lequel est formé la région de cathode du thyristor à gâchette de cathode et le mur d'isolement, d'où il résulte que cette région constitue une résistance disposée entre la gâchette des thyristors à gâchette d'anode et de cathode et l'anode de thyristor à gâchette de cathode et la cathode du thyristor à gâchette d'anode.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2, décrites précédemment, sont destinées à exposer l'état de la technique et le problème posé ;
la figure 3 représente un mode de réalisation d'un commutateur bidirectionnel normalement fermé selon la présente invention ; et
Les figures 4 à 7 représentent divers modes de réalisation d'assemblages monolithiques incorporant au moins les deux thyristors du circuit selon la présente invention.

La figure 3 représente un mode de réalisation d'un commutateur 3 bidirectionnel normalement fermé selon la présente invention. Ce commutateur 3 est destiné, comme un commutateur classique, à être disposé en série avec une charge 35 (Q) entre deux bornes 36, 37 d'application d'une tension alternative d'alimentation Vac, par exemple, la tension du secteur. Le commutateur 3 comporte, comme précédemment, deux bornes de puissance 32, 33 destinées à être connectées, respectivement, à une borne d'application de la tension alternative d'alimentation et à une borne de la charge 35.

Selon l'invention, le commutateur 3 comporte, en parallèle entre les bornes de puissance 32 et 33, un premier thyristor 39 à gâchette de cathode dont l'anode est reliée à une première borne de puissance (par exemple, 33), et un deuxième thyristor 40 à gâchette d'anode dont l'anode est reliée à l'autre borne de puissance (par exemple, 32). Les gâchettes respectives Gc et Ga des thyristors 39 et 40 sont reliées, par l'intermédiaire d'une même résistance R3, à la borne 33 et, par l'intermédiaire d'un interrupteur de commande 34, à la borne 32.

L'interrupteur de commande 34 peut être un interrupteur à actionnement manuel ou un interrupteur actionné par un signal CTRL de commande provenant d'un circuit approprié. Par exemple, l'interrupteur 34 pourra être un transistor bipolaire associé à un optocoupleur.

Le fonctionnement d'un commutateur 3 selon la présente invention est le suivant.

On suppose l'interrupteur 34 ouvert. Au début d'une alternance positive de la tension alternative d'alimentation Vac, un courant circule, depuis la borne 33, dans la résistance R3, puis de la gâchette Gc à la cathode du thyristor 39. Quand ce courant devient supérieur au courant d'amorçage du thyristor 39, ce dernier s'amorce. Le thyristor 39 se bloque à la fin de l'alternance par la disparition du courant le traversant. Au début d'une alternance négative, un courant circule, depuis la borne 32, de l'anode à la gâchette Ga du thyristor 40, puis dans la résistance R3. Quand ce courant devient supérieur au courant d'amorçage du thyristor 40, celui-ci entre en conduction.

Une fermeture de l'interrupteur de commande 34 court-circuite la gâchette Gc et la cathode du thyristor 39, et la gâchette Ga et l'anode du thyristor 40. Par conséquent, les deux thyristors 39 et 40 sont maintenus à l'état bloqué.

De préférence, une diode de protection 41 est intercalée entre la cathode du thyristor 40 et la borne 33. Le rôle de cette diode 41 est de protéger le thyristor 40 lorsqu'il est polarisé en inverse. L'utilité de la diode 41 est liée à la constitution classique du thyristor à gâchette d'anode et, en particulier, à la tenue en tension de la jonction entre la gâchette et la cathode du thyristor 40 qui, comme on le verra par la suite, est une jonction à faible tenue en tension inverse. En l'absence de la diode 41, on ne tiendrait pas en tension quand on applique +V sur la borne 33 et -V sur la borne 32.

Pour le thyristor 39, une telle diode de protection n'est pas nécessaire. En effet, la jonction gâchette-anode tient la tension lors des alternances positives.

Un avantage de la présente invention est qu'en ayant recours exclusivement à des thyristors comme composants actifs de commutation de puissance, on tire profit de la forte sensibilité des thyristors par rapport aux triacs.

Un autre avantage de la présente invention est que l'interrupteur 34 est désormais référencé à la tension alternative d'alimentation.

Un autre avantage de la présente invention est qu'elle minimise le nombre de composants haute tension nécessaires par rapport à un commutateur classique tel qu'illustré par la figure 2.

Un autre avantage de la présente invention est que le faible courant de déclenchement du commutateur autorise l'emploi d'interrupteurs basse tension grâce à la valeur élevée de la résistance R3. Par exemple, on pourra utiliser un transistor bipolaire ou MOS basse tension, un microrelais, un optocoupleur, etc.

A titre d'exemple particulier de réalisation, on pourra utiliser des thyristors ayant des courants de gâchette de l'ordre de 100 µA. Dans ce cas, la résistance pourra avoir une valeur de l'ordre de 200 kΩ, ce qui conduit à une puissance dissipée de l'ordre de 100 mW quand le commutateur 34 est fermé.

Sous forme de circuit intégré, la résistance R3 pourra être une résistance non linéaire en tension (à coefficient positif), c'est-à-dire dont la valeur augmente avec la tension à ses bornes. Un avantage est alors que la puissance dissipée est minimisée sans nuire à la capacité d'amorçage des thyristors au début de chaque alternance.

A partir de la solution proposée par la présente invention, on pourrait penser utiliser deux thyristors à gâchette de cathode montés en antiparallèle à la place du thyristor à gâchette de cathode et du thyristor à gâchette d'anode. Une telle solution ne présenterait cependant pas tous les avantages de la présente invention. En effet, cela impliquerait un circuit de commande plus complexe, augmentant ainsi le nombre de composants nécessaires. Par exemple, il faudrait alors utiliser deux résistances respectivement associées aux gâchettes des thyristors ainsi que deux interrupteurs pour ouvrir le commutateur.

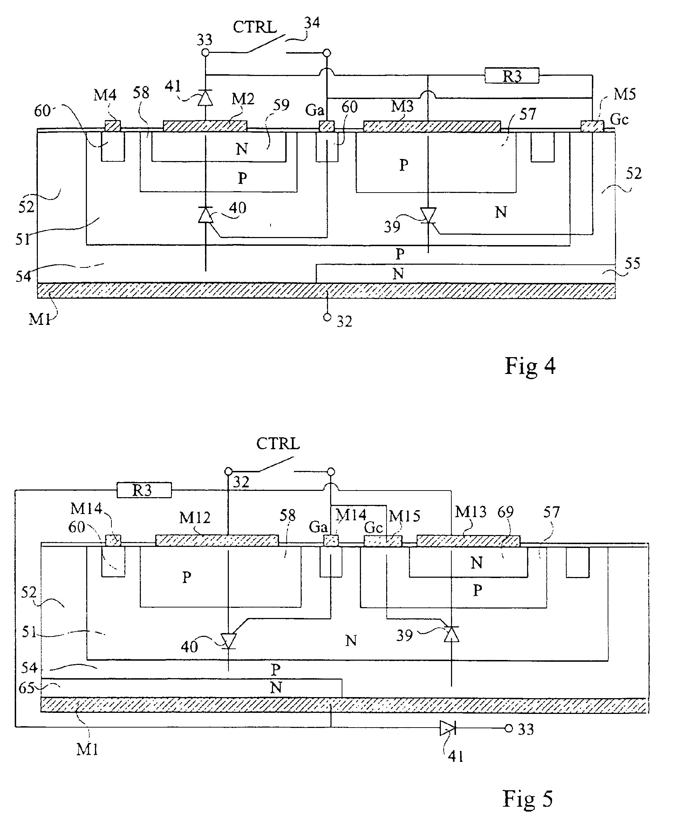

La figure 4 représente un premier exemple d'assemblage monolithique des deux thyristors 39 et 40. Ces deux thyristors sont des thyristors verticaux formés dans un même substrat de silicium de type N faiblement dopé 51. Ce substrat, ou la portion de substrat dans laquelle sont formés les thyristors, est délimité par un mur d'isolement de type P fortement dopé 52. La face arrière de la structure comprend une couche de type P 54 dans laquelle est formée, du côté droit de la figure, une région fortement dopée de type N 55. La face arrière de la structure est revêtue d'une métallisation M1.

Du côté de la face avant, sont formés deux caissons de type P 57 et 58, le caisson 57 étant en regard de la région de type N de face arrière 55. Dans le caisson 58 est formée une région de type N 59. Une région de type N fortement dopée 60 est formée dans le substrat à la périphérie du caisson 58. Une métallisation M2 est formée sur la région 59, une métallisation M3 sur la région 57, une métallisation M4 sur la région 60, et une métallisation M5 sur le mur d'isolement 52, du côté droit de la figure. On a ainsi formé un thyristor à gâchette de cathode 39 dont l'anode correspond à la région 57 et la cathode à la région 55. La métallisation M5 correspond à la métallisation de gâchette de ce thyristor 39. On a également formé un thyristor à gâchette d'anode 40 dont l'anode correspond à la couche 54 et la cathode à la région 59. La métallisation M4 constitue la métallisation de gâchette de ce thyristor 40. On a également représenté dans la figure comment sont connectés ces thyristors avec les composants décrits en relation avec la figure 3. On remarquera que, dans ce mode de réalisation, la diode 41 est formée à l'extérieur du composant monolithique. On notera qu'elle peut également être formée dans ce même composant à l'extérieur de la région délimitée par le mur d'isolement 52, en utilisant par exemple des techniques d'assemblages de composants de puissance telles que décrites par la demanderesse dans la demande de brevet Européen 721 218 intitulée "circuits intégrés de puissance".

La figure 5 représente un autre mode de réalisation d'un assemblage de thyristors selon la présente invention. Dans ce cas, l'anode du thyristor à gâchette d'anode 40 et la cathode du thyristor à gâchette de cathode 39 se trouvent du côté de la face supérieure du composant.

Comme dans la figure précédente, une portion d'un substrat de type N faiblement dopé 51 est délimitée par un mur d'isolement de type P 52. La face arrière comporte une couche uniforme de type P 54. Cette fois ci, une région de type N 65 formée à partir de la face inférieure, se trouve du côté gauche de la figure (le côté du thyristor à gâchette d'anode). Le caisson 57 du thyristor à gâchette de cathode 39 contient une région de type N fortement dopée 69 alors que le caisson d'anode 58 du thyristor à gâchette d'anode ne contient pas de couche N. Comme précédemment, le caisson 58 est entouré d'une région de type N fortement dopée 60. Comme précédemment, on a une métallisation M1 de face arrière. Une métallisation M12 recouvre la région d'anode 58 du thyristor 40. Une métallisation M13 recouvre la région de cathode 69 du thyristor 39. Une métallisation M14 recouvre l'anneau de type N 60. La gâchette du thyristor à gâchette de cathode 39 est formée sur une portion du caisson 57 et est désignée par la référence M15.

Ceci constitue une variante de réalisation de la structure selon la présente invention. Elle présente par rapport à la précédente l'avantage que le thyristor à gâchette de cathode est plus sensible, c'est-à-dire qu'il se déclenchera pour un plus faible courant de gâchette tandis que le thyristor à gâchette d'anode 40 est légèrement moins sensible.

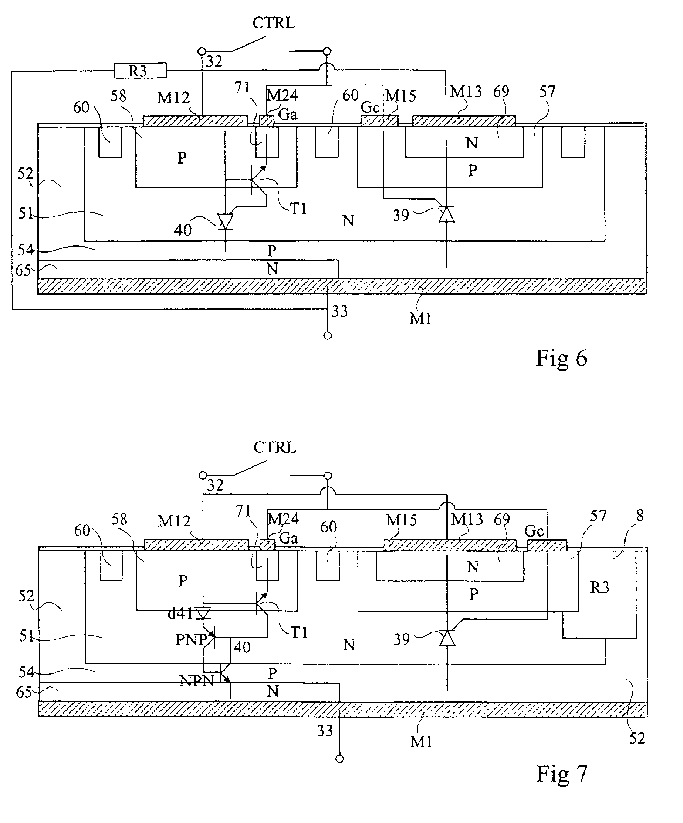

La figure 6 représente un autre mode de réalisation de la présente invention. La structure de couches de ce mode de réalisation est sensiblement identique à celle de la figure 5. De même régions y sont désignées par de même références et ne seront pas décrites à nouveau. La différence entre les structures des figures 6 et 5 est que, en figure 6, il n'y a plus de métallisation sur l'anneau 60, cet anneau ayant alors seulement une fonction classique d'arrêt de canal. La métallisation de gâchette M24 du thyristor à gâchette d'anode est réalisée sur une région de type P 71 formée dans le caisson d'anode 58 du thyristor 40. On obtient ainsi une structure de thyristor dite "à gâchette éloignée". L'amorçage du thyristor est déclenché par un petit transistor T1 constitué des régions 71, 58 et 51, connecté au thyristor 40 de la façon illustrée en figure 6. L'avantage de cette structure réside dans le fait que le thyristor 40 est alors auto-protégé en cas de présence d'une tension positive élevée sur la métallisation de face arrière M1. La diode 41 fait alors partie intégrante de la structure et correspond à la jonction entre les régions 58 et 51, cette diode ayant comme on l'a indiqué précédemment pour fonction de protéger le thyristor à gâchette d'anode d'un déclenchement parasite en inverse entre gâchette et cathode quand la cathode est à une tension positive élevée.

La figure 7 représente un autre mode de réalisation de la présente invention.

Ce mode de réalisation est pour l'ensemble identique à celui illustré en figure 6 et de mêmes éléments sont désignés par de mêmes références. Du côté gauche de la figure, on a représenté le thyristor 40 par des transistors équivalents pour mieux faire voir la diode d41 remplissant la fonction de la diode 41 du circuit de la figure 3. Outre les régions et couches représentées en figure 6, la structure de la figure 3 comprend une région de type P faiblement dopée 81 qui s'étend entre le caisson 57 et le mur d'isolement 52. En d'autres termes, cette région 81 s'étend entre la gâchette du thyristor 39 et la métallisation M1 commune à l'anode du thyristor 39 et la cathode du thyristor 40. Elle remplit donc la fonction de la résistance R3 de la figure 3. Ainsi, l'ensemble des éléments du commutateur bidirectionnel 3 de la figure 3 sont intégrés dans la structure de la figure 7 à l'exception de l'interrupteur commandable 34. Toutefois, comme on l'a indiqué précédemment, l'homme de métier pourra réaliser ce commutateur dans le même composant monolithique en utilisant les techniques indiquées précédemment.

Ainsi, la figure 7 représente une structure monolithique intégrant un commutateur bidirectionnel normalement fermé selon la présente invention. L'homme de l'art saura choisir les dimensions et les niveaux de dopage des diverses couches pour atteindre les objectifs visés de puissance et de sensibilité de déclenchement.

Bien entendu, la présente invention est susceptible de diverses variantes et modifications qui apparaîtront à l'homme de l'art. En particulier, les caractéristiques de tension et de sensibilité des thyristors à gâchette de cathode et à gâchette d'anode, ainsi que la valeur de la résistance R3 seront adaptées à l'application à laquelle est destiné le commutateur. De plus, on notera que l'invention se transpose à la réalisation d'un commutateur normalement ouvert. Pour ce faire, il suffit de supprimer la résistance R3 et l'interrupteur 34, et de prévoir un circuit de commande injectant un courant de gâchette pendant les périodes de fermeture.

## Revendications

1. Commutateur bidirectionnel normalement fermé, comportant, en parallèle entre deux bornes (32, 33) de puissance du commutateur (3), un premier thyristor (39) à gâchette de cathode, dont l'anode est reliée à une première borne (33) de puissance ; un deuxième thyristor (40) à gâchette d'anode, dont l'anode est reliée à une deuxième borne de puissance (32) ; et **caractérisé en ce qu'**il comporte en outre, en parallèle, sur les thyristors une résistance (R3) en série avec un interrupteur commandable (34), le point-milieu de cette association en série étant relié aux gâchettes respectives des deux thyristors.

2. Commutateur selon la revendication 1, **caractérisé en ce que** les thyristors (39, 40) sont choisis pour présenter un faible courant d'amorçage.

3. Commutateur selon la revendication 1 ou 2, **caractérisé en ce qu'**une diode (41) de protection est intercalée entre la cathode du thyristor à gâchette d'anode (40) et la première borne de puissance (33).

4. Commutateur selon l'une quelconque des revendications 1 à 3, **caractérisé en ce que** la résistance (R3) est de forte valeur, choisie en fonction des courants d'amorçage respectifs des deux thyristors (39, 40).

5. Commutateur selon l'une quelconque des revendications 1 à 4, **caractérisé en ce qu'**au moins les deux thyristors (39, 40) sont intégrés.

6. Commutateur selon les revendications 3 et 4, **caractérisé en ce qu'**au moins les deux thyristors (39, 40), la diode de protection (41) et la résistance (R3) sont intégrés au sein d'un même circuit.

7. Commutateur selon la revendication 6, **caractérisé en ce que** la résistance (R3) est non linéaire.

8. Composant semiconducteur monolithique intégrant les deux thyristors du commutateur bidirectionnel selon la revendication 1, **caractérisé en ce que** ces thyristors sont réalisés sous forme verticale dans une portion d'un substrat de type N (51) faiblement dopé entourée d'un mur d'isolement de type P (52).

9. Composant selon la revendication 8, **caractérisé en ce que**
l'anode du thyristor à gâchette d'anode (40) et la cathode du thyristor à gâchette de cathode (39) sont disposées du côté de la face arrière du composant revêtue d'une métallisation unique (M1),
la gâchette du thyristor à gâchette de cathode est prise sur le mur d'isolement (52) du côté de la face avant du composant, et
la gâchette d'anode du thyristor à gâchette d'anode (40) est constituée d'un anneau (60) entourant un caisson de type P (58) dans lequel est formé une couche de cathode (59) du composant, du côté de la face avant.

10. Composant selon la revendication 8, **caractérisé en ce que**
l'anode du thyristor à gâchette de cathode (39) et la cathode du thyristor à gâchette d'anode (40) sont disposées du côté de la face arrière du composant revêtue d'une métallisation unique (M1),
la gâchette du thyristor à gâchette d'anode est constituée d'un anneau (60) entourant un caisson (58) de type P constituant la région d'anode du thyristor, et
la métallisation de gâchette (M15) du thyristor à gâchette de cathode (39) est formée du côté de la face supérieure du substrat sur un caisson de type P (57) contenant une région de type N (69) formant la cathode du thyristor à gâchette de cathode.

11. Composant selon la revendication 8, **caractérisé en ce que**
l'anode du thyristor à gâchette de cathode (39) et la cathode du thyristor à gâchette d'anode (40) sont disposées du côté de la face arrière du composant et revêtues d'une métallisation unique (M1),
la gâchette du thyristor à gâchette d'anode est du type gâchette éloignée et est constituée d'une région de type N (71) formée dans le caisson d'anode (58) du thyristor à gâchette d'anode, d'où il résulte que le thyristor à gâchette d'anode est protégé contre des claquages résultant de tensions inverses élevées, et
la métallisation de gâchette (M15) du thyristor à gâchette de cathode (39) est formée du côté de la face supérieure du substrat sur un caisson de type P (57) contenant une région de type N (69) formant la cathode du thyristor à gâchette de cathode.

12. Composant selon la revendication 11, **caractérisé en ce qu'**il comprend une région de type P faiblement dopé (81) s'étendant entre le caisson de type P (57) dans lequel est formé la région de cathode (69) du thyristor à gâchette de cathode (39) et le mur d'isolement (52), d'où il résulte que cette région (81) constitue une résistance (R3) disposée entre la gâchette des thyristors à gâchette d'anode et de cathode et l'anode de thyristor à gâchette de cathode et la cathode du thyristor à gâchette d'anode.

## Claims

1. A normally-on bidirectional switch, including, in parallel between two power terminals (32, 33) of the switch (3), a first cathode-gate thyristor (39), the anode of which is connected to a first power terminal (33); a second anode-gate thyristor (40), the anode of which is connected to a second power terminal (32); and **characterized in that** it further includes a resistor (R3) in series with a controllable switch (34), the midpoint of this series association being connected to the respective gates of the two thyristors.

2. The switch of claim 1, **characterized in that** the thyristors (39, 40) are chosen to have a low triggering current.

3. The switch of claim 1 or 2, **characterized in that** a protection diode (41) is interposed between the cathode of the anode-gate thyristor (40) and the first power terminal (33).

4. The switch of any of claims 1 to 3, **characterized in that** the resistor (R3) has a high resistance, selected as a function of the respective triggering currents of the thyristors (39, 40).

5. The switch of any of claims 1 to 4, **characterized in that** at least the two thyristors (39, 40) are integrated.

6. The switch of claims 3 and 4, **characterized in that** at least the two thyristors (39, 40), the protection diode (41), and the resistor (R3) are integrated within a same circuit.

7. The switch of claim 6, **characterized in that** the resistor (R3) is non-linear.

8. A monolithic semiconductor component integrating the two thyristors of the bidirectional switch of claim 1, **characterized in that** the thyristors are implemented in vertical form in a portion of a lightly-doped N-type substrate (51) surrounded with a P-type isolating wall (52).

9. The component of claim 8, **characterized in that**:
the anode of the anode-gate thyristor (40) and the cathode of the cathode-gate thyristor (39) are arranged on a rear surface of the component coated with a single metallization (M1),
the gate of the cathode-gate thyristor is taken on the isolating wall (52) on a front surface of the component, and
the anode gate of the anode-gate thyristor (40) is formed of a ring (60) surrounding a P-type well (58) in which is formed a cathode layer (59) of the component, on the front surface side.

10. The component of claim 8, **characterized in that**:
the anode of the cathode-gate thyristor (39) and the cathode of the anode-gate thyristor (40) are arranged on a rear surface of the component coated with a single metallization (M1),
the gate of the anode-gate thyristor is formed of a ring (60) surrounding a P-type well (58) forming the anode region of the thyristor, and
the gate metallization (M15) of the cathode-gate thyristor (39) is formed on an upper surface side of the substrate on a P-type well (57) containing an N-type region (69) forming the cathode of the cathode-gate thyristor.

11. The component of claim 8, **characterized in that**:
the anode of the cathode-gate thyristor (39) and the cathode of the anode-gate thyristor (40) are arranged on a rear surface of the component and coated with a single metallization (M1),
the gate of the anode-gate thyristor is of remote gate type and is formed of an N-type region (71) formed in the anode well (58) of the anode-gate thyristor, whereby the anode-gate thyristor is protected against overvoltages resulting from high reverse voltages, and
the gate metallization (M15) of the cathode-gate thyristor (39) is formed on an upper surface of the substrate on a P-type well (57) containing an N-type region (69) forming the cathode of the cathode-gate thyristor.

12. The component of claim 11, **characterized in that** it includes a lightly-doped P-type region (81) extending between the P-type well (57) in which the cathode region (69) of the cathode-gate thyristor (39) is formed and the isolating wall (52), whereby this region (81) forms a resistor (R3) arranged between the gate of the anode- and cathode-gate thyristors and the anode of the cathode-gate thyristor and the cathode of the anode-gate thyristor.

## Patentansprüche

1. Ein normalerweiser offener Zweirichtungsschalter, der parallel zwischen zwei Leistungsanschlüssen (32, 33) des Schalters (3) Folgendes aufweist:
einen ersten Kathoden-Gate-Thyristor (39), dessen Anode mit dem ersten Leistungsanschluss (33) verbunden ist;
einen zweiten Anoden-Gate-Thyristor (40), dessen Anode mit einem zweiten Leistungsanschluss (32) verbunden ist;
und ferner **dadurch gekennzeichnet, dass** weiterhin ein Widerstand (R3) in Serie mit einem steuerbaren Schalter (34) vorgesehen ist, wobei der Mittelpunkt dieser Serienzuordnung mit den entsprechenden Gates der zwei Thyristoren verbunden ist.

2. Schalter nach Anspruch 1, **dadurch gekennzeichnet, dass** die Thyristoren (39, 40) derart ausgewählt sind, dass sie einen niedrigen Trigger- oder Auslösestrom besitzen.

3. Schalter nach Anspruch 1 oder 2, **dadurch gekennzeichnet, dass** eine Schutzdiode (41), zwischen der Kathode des Anoden-Gate-Thyristors (40) und dem ersten Leistungsanschluss (33) eingesetzt ist.

4. Schalter nach einem der Ansprüche 1 bis 3, **dadurch gekennzeichnet, dass** der Widerstand (R3) einen hohen Widerstandswert besitzt, und zwar ausgewählt als Funktion der entsprechenden Triggerströme der Thyristoren (39, 40).

5. Schalter nach einem der Ansprüche 1 bis 4, **dadurch gekennzeichnet, dass** mindestens die zwei Thyristoren (39, 40) integriert ausgebildet sind.

6. Schalter nach Ansprüchen 3 und 4, **dadurch gekennzeichnet, dass** mindestens die zwei Thyristoren (39, 40), die Schutzdiode (41) und der Widerstand (R3) innerhalb derselben Schaltung integriert sind.

7. Schalter nach Anspruch 6, **dadurch gekennzeichnet, dass** der Widerstand (R3) nicht-linear ist.

8. Eine monolithische Halbleiterkomponente, die zwei Thyristoren des bidirektionalen Schalters des Anspruchs 1 integriert, **dadurch gekennzeichnet, dass** die Thyristoren in Vertikalform in einem Teil eines leicht dotierten N-Typ Substrats (51), umgeben von einer P-Typ Isolationswand (52), implementiert sind.

9. Komponente nach Anspruch 8, **dadurch gekennzeichnet, dass**:
die Anode des Anoden-Gate-Thyristors (40) und die Kathode des Kathoden-Gate-Thyristors (39) auf einer hinteren Oberfläche der mit einer einzigen Metallisierung (M1) beschichteten Komponente angeordnet sind,
das Gate des Kathoden-Gate-Thyristors auf der Isolationswand (52) auf einer vorderen Oberfläche der Komponente vorgesehen wird; und
das Anoden-Gate des Anoden-Gate-Thyristors (40) als ein Ring (60) eine P-Typ Vertiefung (well) (58) umgebend ausgebildet ist, wohin eine Kathodenschicht (59) der Komponente geformt ist, und zwar auf der vorderen Oberflächenseite.

10. Komponente nach Anspruch 8, **dadurch gekennzeichnet, dass**:
die Anode des Kathoden-Gate-Thyristors (39) und die Kathode des Anoden-Gate-Thyristors (40) auf der hinteren Oberfläche der Komponente, beschichtet mit einer einzigen Metallisierung (M1), angeordnet sind,
das Gate des Anoden-Gate-Thyristors aus einem Ring (60) geformt ist, der eine P-Typ Vertiefung (58) umgibt, die die Anodenzone des Thyristors bildet, und
die Gate-Metallisierung (M15) des Kathoden-Gate-Thyristors (39) auf einer die obere Oberfläche bildenden Seite des Substrats auf einer P-Typ Vertiefung (57) ausgebildet ist, die eine N-Typ Zone (69) enthält, und zwar die Kathode des Kathoden-Gate-Thyristors bildend.

11. Komponente nach Anspruch 8, **dadurch gekennzeichnet, dass**:
die Anode des Kathoden-Gate-Thyristors (39) und die Kathode des Anoden-Gate-Thyristors (40) auf einer hinteren Oberfläche der Komponente angeordnet sind und mit einer einzigen Metallisierung (M1) beschichtet sind,
das Gate des Anoden-Gate-Thyristors von der entfernten (remote) Gatebauart ist und geformt ist aus einer N-Typ Zone (71), gebildet in der Anodenvertiefung (58) des Anoden-Gate-Thyristors, wodurch der Anoden-Gate-Thyristor gegenüber Überspannung geschützt ist, die sich aus hohen Gegenspannungen ergeben, und
die Gate-Metallisierung (M15) des Kathoden-Gate-Thyristors (39) auf einer oberen Oberfläche des Substrats auf einer P-Typ Vertiefung (57) gebildet ist, die eine N-Typ Zone (69) enthält, und zwar die Kathode des Kathoden-Gate-Thyristors bildend.

12. Komponente nach Anspruch 11, **dadurch gekennzeichnet, dass** sie eine leicht dotierte P-Typ Zone (81) aufweist, die sich zwischen der P-Typ Vertiefung (57), in der die Kathodenzone (69) des Anoden-Gate-Thyristors (39) geformt ist und der Isolationswand (52) erstreckt, wodurch diese Zone (81) einen Widerstand (R3) bildet, und zwar angeordnet zwischen dem Gate der Anoden- und Kathoden-Gate-Thyristoren und der Anode des Kathoden-Gate-Thyristors und der Kathode des Anoden-Gate-Thyristors.
